# EUROPEAN PATENT APPLICATION

(11) **EP 3 182 342 A1**
(43) Date of publication of application: **21.06.2017**
(21) Application number: 16203361.7
(22) Date of filing: 12.12.2016
(51) Int. Cl.: G06Q 10/00

(54) **CONTEMPORANEOUS DATA RECORDING AND RELIABILITY MODELING WITH TURBOMACHINE SERVICE OUTAGE**

(30) Priority: 15.12.2015 US 201514969301
(71) Applicant: General Electric Company, Schenectady, NY 12345 (US)
(72) Inventor: VEITCH, Christiane Mary, West Grove, PA Pennsylvania 19390 (US); ACKERKNECHT, Charles John, Greenville, SC South Carolina 29615 (US); BOJAPPA, Parvangada Ganapathy, Greenville, SC South Carolina 29615 (US); CRAWFORD, Kerry Wayne, Greenville, SC South Carolina 29615 (US); HERNANDEZ, Alberto, Greenville, SC South Carolina 29615 (US); KEMP JR, Preston Butler, Greenville, SC South Carolina 29615 (US); SEELY, Melissa Ann, Greenville, SC South Carolina 29615 (US)
(74) Representative: Pöpper, Evamaria

(57) **Abstract**

A method, system and program product for contemporaneous data recording and/or reliability modeling (162) with a turbomachine (100) service outage is provided. A database (170) including impairment data for the turbomachine (100) is provided. An impairment mode is recorded in the database (170) for at least one of a part or an event from a plurality of predetermined impairment modes contemporaneously with a service outage of the turbomachine (100). The method also includes modeling a reliability (162) of at least one of the part and the event based on the database (170) contemporaneously with the service outage. Embodiments may also include using the reliability modeling (162) to control operation of the turbomachine (100) after the service outage.

## Description

The present disclosure relates to turbomachines, and more specifically, to a method, a system and a program product for contemporaneous data recording and modeling with a service outage of a turbomachine. Embodiments of the disclosure may also include controlling a turbomachine based on contemporaneous reliability modeling.

Turbomachines such as gas turbines, steam turbines and jet engines are used widely to generate power. When an unexpected outage occurs or an unrepairable part is identified (e.g., during routine maintenance) in a turbomachine, data is collected and evaluated to identify root causes of the unplanned outage or unrepairable part. Currently, data from a wide variety of sources and locations is collected over a relatively long period of time, e.g., many months or a year. Once the data is collected an evaluation is conducted and updated reliability modeling is performed, incorporating the data collected from the outage or unrepairable part. The time lapse from the point of unplanned outage or unrepairable part to the time when reliability modeling is performed leads to inaccurate or poor modeling. The poor results can be caused by a number of issues such as personnel lack of recollection and/or failure to collect relevant or necessary data about the outage or unrepairable part. The latter issue can take a number of forms such as information about the cause of an outage or unrepairable part being incorrectly categorized, parts being identified as unfixable (i.e., scrap) but for unknown or inadequate reasons, etc. Collecting the desired data later oftentimes proves impossible. In addition, since the evaluation is conducted only periodically, the volume of evaluations that need to be performed can be heavy.

In some cases, the turbomachine are controlled by a control system that employs the reliability model to proactively identify problems, indicate necessary maintenance and generally act to improve performance, prolong operational life and reduce unplanned outages of the machines. The control system typically can control a wide variety of operational parameters of the turbomachine, e.g., working fluid flow, pressures, fuel consumption, etc., through various control mechanisms, e.g., valves, pumps, motors, etc. The aforementioned challenges regarding data collection after a service outage can also impact the control system.

A first aspect of the disclosure relates to a system for controlling a turbomachine, the system comprising: a database including impairment data for the turbomachine; a recorder recording in the database an impairment mode for at least one of a part or an event from a plurality of predetermined impairment modes contemporaneously with a service outage of the turbomachine; and a reliability modeler modeling a reliability of the at least one of the part and the event based on the database contemporaneously with the service outage.

A second aspect of the disclosure is directed to a method for controlling a turbomachine including a plurality of parts, the method comprising: providing a database including impairment data for the turbomachine; recording in the database an impairment mode for at least one of a part or an event from a plurality of predetermined impairment modes contemporaneously with a service outage of the turbomachine; modeling a reliability of the at least one of the part and the event based on the database contemporaneously with the service outage; and using the reliability modeling to control operation of the turbomachine after the service outage.

A third aspect of the disclosure includes a computer program product to perform the above method.

The foregoing and other features of the disclosure will be apparent from the following more particular description of embodiments of the disclosure.

The embodiments of this disclosure will be described in detail, with reference to the following figures, wherein like designations denote like elements, and wherein:
FIG. 1 shows a schematic view of a turbomachine according to embodiments of the present disclosure.
FIG. 2 shows a schematic block diagram of a contemporaneous data collection and modeling (CDCM) system according to embodiments of the disclosure.
FIG. 3 shows a flow diagram of an operational methodology of the CDCM system of FIG. 2 according to embodiments of the disclosure.
FIG. 4 shows an illustrative graphical user interface according to embodiments of the disclosure.
FIG. 5 shows a schematic block diagram of a control system according to an alternative embodiment of the disclosure.
FIG. 6 shows a flow diagram of an operational methodology for control system of FIG. 5 according to an alternative embodiment of the disclosure.

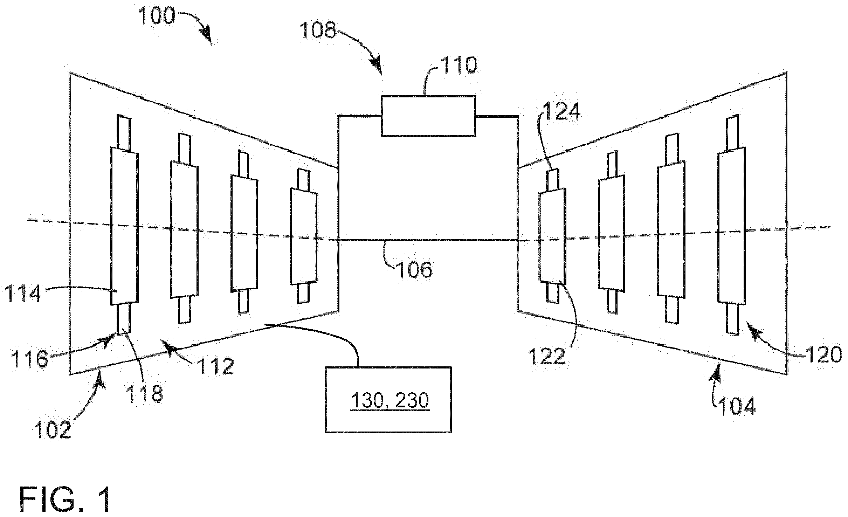

FIG. 1 shows a schematic block diagram of an illustrative turbomachine 100 in the form of a gas turbine system. Turbomachine 100 may include a compressor portion 102 operatively coupled to a turbine portion 104 through a shared compressor/turbine shaft 106. Compressor portion 102 is also fluidically connected to turbine portion 104 through a combustor assembly 108. Combustor assembly 108 includes one or more combustors 110. Combustors 110 may be mounted to turbomachine 100 in a wide range of configurations including, but not limited to, being arranged in a can-annular array. Compressor portion 102 includes a plurality of compressor rotor wheels 112. Rotor wheels 112 include a first stage compressor rotor wheel 114 having a plurality of first stage compressor rotor blades 116 each having an associated airfoil portion 118. Similarly, turbine portion 104 includes a plurality of turbine rotor wheels 120 including a first stage turbine wheel 122 having a plurality of turbine buckets 124, e.g., provided as first stage turbine rotor blades. Stationary blades within turbine portion 104 can direct gases through turbine portion 104 against turbine buckets 124 of turbine portion 104. Any of the aforementioned structures may include a wide variety of parts that may cause service outages in turbomachine. Although embodiments of the present disclosure may be described as used with the illustrated gas turbine system, embodiments of the present disclosure can be adapted for use in other forms of turbomachinery, e.g., steam turbines, jet engines, water turbines, independent compressors, etc.

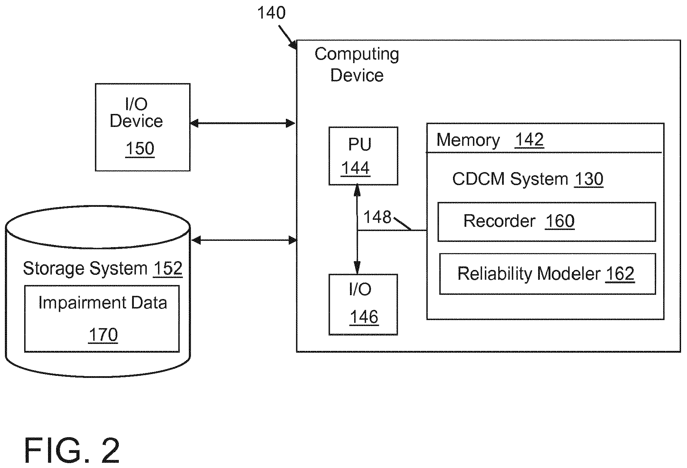

With reference to FIG. 2, a schematic block diagram of a contemporaneous data collection and modeling (CDCM) system 130 in accordance with the disclosure is illustrated. CDCM system 130 is shown implemented on computer 140 as computer program code. To this extent, computer 140 is shown including a memory 142, a processor (PU) 144, an input/output (I/O) interface 146, and a bus 148. Further, computer 140 is shown in communication with an external I/O device/resource 150 and a storage system 152. In general, processor 144 executes computer program code, such as CDCM system 130, that is stored in memory 142 and/or storage system 152. While executing computer program code, processor 144 can read and/or write data to/from memory 142, storage system 152, and/or I/O device 146. Bus 148 provides a communication link between each of the components in computer 140, and I/O device 146 can comprise any device that enables user to interact with computer 140 (e.g., keyboard, pointing device, display, etc.).

Alternatively, a user can interact with another computing device (not shown) in communication with computer 140. In this case, I/O interface 146 can comprise any device that enables computer 140 to communicate with one or more other computing devices over a network (e.g., a network system, network adapter, I/O port, modem, etc.). The network can comprise any combination of various types of communications links. For example, the network can comprise addressable connections that may utilize any combination of wireline and/or wireless transmission methods. In this instance, the computing devices (e.g., computer 140) may utilize conventional network connectivity, such as Token Ring, Ethernet, WiFi or other conventional communications standards. Further, the network can comprise one or more of any type of network, including the Internet, a wide area network (WAN), a local area network (LAN), a virtual private network (VPN), etc. Where communications occur via the Internet, connectivity could be provided by conventional TCP/IP sockets-based protocol, and a computing device could utilize an Internet service provider to establish connectivity to the Internet.

Computer 140 is only representative of various possible combinations of hardware and software. For example, processor 144 may comprise a single processing unit, or be distributed across one or more processing units in one or more locations, e.g., on a client and server. Similarly, memory 142 and/or storage system 152 may reside at one or more physical locations. Memory 142 and/or storage system 142 can comprise any combination of various types of computer-readable media and/or transmission media including magnetic media, optical media, random access memory (RAM), read only memory (ROM), a data object, etc. I/O interface 146 can comprise any system for exchanging information with one or more I/O devices. Further, it is understood that one or more additional components (e.g., system software, math co-processor, etc.) not shown in FIG. 2 can be included in computer 140. To this extent, computer 140 can comprise any type of computing device such as a network server, a desktop computer, a laptop, etc. It is understood that one or more I/O devices (e.g., a display) and/or storage system 152 could be contained within computer 140, not externally as shown.

For clarity, CDCM system 130 is shown with only those components that are relevant to operation of the disclosure. For purposes of the disclosure, CDCM system 130 may include a recorder 160 and a reliability modeler 162.

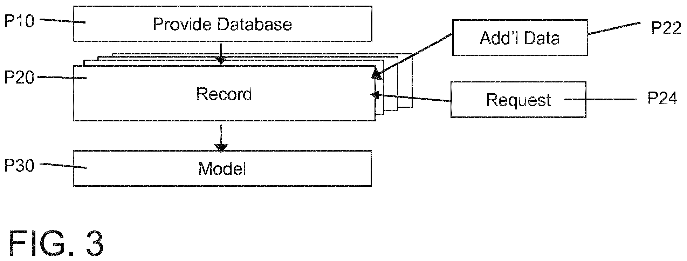

FIG. 3 shows a flow diagram of an embodiment of a method for controlling turbomachine 100 including a plurality of parts is illustrated. Referring to FIGS. 2 and 3 collectively, operation of CDCM system 130 will not be described.

In process P10, a database 170 including impairment data for turbomachine 100 is provided. Database 170 may be stored in memory 142 or, as illustrated, in storage system 152, for access by CDCM system 130. "Impairment data" may include any now known or later developed information that relates to diminished performance, damage or inoperability of turbomachine 100 for at least one of a part or an event, i.e., that relates to the impairment. Impairment data thus can include data regarding a number of parts that have some attribute that impairs turbomachine 100 such as a worn surface or unrepairable structure, or impairment data may include a number of identifiable events related to turbomachine 100 such as unplanned outages, drops in performance, startup, shut down, changes in operation, etc. Each part and/or event in database 170 may include one or more "impairment modes" that acts to categorize the part and/or event. For example, each unrepairable part may have an impairment mode that identifies such aspects as repair type, suspected cause, reason for scrapping part, repairs made and/or how made, age of part, whether repaired previously and any other attributes that may relate to the part. In terms of an event such as an unplanned outage or drop in performance, the impairment mode may include, for example, event type, turbomachine operating parameters at the time of the event, environmental conditions at the time of the event, and any other attributes that may impact the turbomachine operation at the time of the event.

In process P20, recorder 160 records an impairment mode in database 170 for at least one of a part or an event from a plurality of predetermined impairment modes contemporaneously with a service outage of the turbomachine. In contrast to conventional processes, CDCM system 130 provides contemporaneous impairment data collection, and also allows for more accurate impairment data collection by requiring selection from predetermined impairment modes, rather than random, user defined modes. The recording can occur for any number of parts evaluated during a service outage. The event can take the form of any of the heretofore described events, e.g., performance drop, planned outage. In one embodiment, the service outage includes an unplanned outage, but could also include a planned outage.

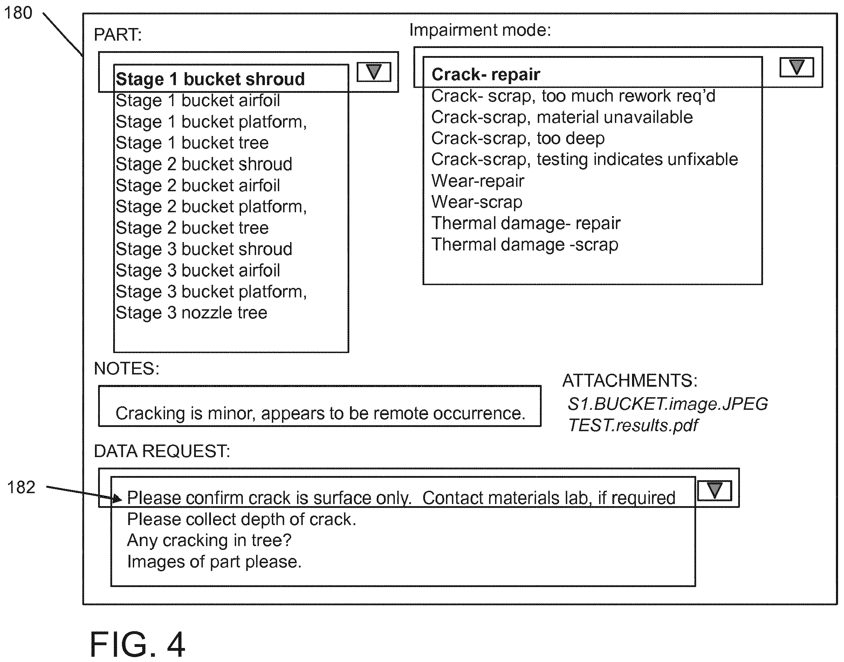

Recording of the impairment mode P20 can take a variety of forms. In one embodiment, the impairment mode may be automatically generated based on predefined impairment modes based on operational attributes of turbomachine 100 at the time of an event, e.g., temperature, pressure, weather, etc. Each operational attribute may indicate a particular impairment mode, or collectively a group of operational attributes may indicate an impairment mode. For example, an operational temperature, pressure, speed, etc., in a normal setting of turbomachine 100 may be a "normal" impairment mode, while an operational temperature that is high at a particular stage of turbomachine 100 may be a "stage n, high temp" impairment mode for the event. In another embodiment, impairment modes may be manually entered by a user using, for example, a graphical user interface (GUI) that delineates the predefined impairment modes for the event and/or part. For example, FIG. 4 shows an illustrative GUI 180 presented by CDCM system 130 to a part repair-person. In the example shown, a repair-person can enter a part into GUI 180, e.g., using a drop down window, or simple entry. Based on the part, CDCM system 130 can provide a predetermined list of impairment modes from which the repair-person can select to describe the part, e.g., using a drop down window. In this fashion, any part for which information is desired, can be provided to a user, and whatever impairment mode is desired about the part can be predefined and collected. It is emphasized that the parts listed and the impairment modes listed are simplified for purposes of description here. In addition, "part" can be any variety of parts, sub-parts, areas of parts, etc., and "impairment mode" can be any variety of impairment modes possible to categorize the part.

Referring to FIGS. 2-4, in process P22, recorder 160 may also record additional data regarding the at least one of the part and the event. In one embodiment, this process may include the part and impairment mode being sub-categorized, if desired, e.g., with additional entry windows based on entries therein. For example, for a part, a drop down window could provide an area of the part to which the impairment mode applies. In another embodiment, notes can also be collected, if desired, or attachments collected, e.g., using conventional file attachment techniques. In another embodiment, the additional data may include an image of a part, e.g., as a file attachment. Attachments are shown as "S1-BUCKET.image.jpeg" and "TEST.results.pdf" in FIG. 4. In another example, in response to the part being identified, for example, as 'scrap', testing may be performed on the part and recorder 160 may record a result of the testing in the database, e.g., by entry into fields of a GUI or as a file attachment (shown in FIG. 4). In any event, GUI 180 can be arranged to collect any additional data desired.

In process P24, recorder 160 may provide a GUI (shown in FIG. 4 as GUI 180 but could be separate) that allows for a request 182 for additional data regarding the at least one of the part and the event to be entered, e.g., by an evaluator. Request 182 can be automated in recorder 160 to obtain certain data, e.g., from a turbomachine control system upon an unplanned service outage. Alternatively, request 182 can be provided in GUI 180 for manual collection by, for example, an engineer or part repair-person. In any event, recorder 160 records the additional data regarding the at least one of the part and the event based on the request, e.g., automatically based on data known at the time of the event or about the part at the time of the service outage, or manually in, for example, notes or other entry windows, by a user upon reviewing GUI 180.

As shown in FIG. 3 relative to process P20, recorder 160 may allow recording to occur at a plurality of collection nodes (shown in FIG. 3 as numerous processes P20) such that a number of recordings are performed. Each collection node may take the form of a location such as but not limited to: one or more part repair locations, a turbomachine location, a test lab location, etc., but can also take a variety of other forms such as but not limited to: automatically via a control system of turbomachine 100 at the time of the event, sensors on parts of turbomachine 100 at the time of the event, etc.

In process P30, reliability modeler 162 models a reliability of at least one of the part and the event based on the database contemporaneously with the service outage. Reliability modeler 162 may employ any now known or later developed modeling algorithm to generate a model of reliability based on part and/or event. For example, reliability models may be generated using counts of unrepairable parts versus counts of repairable parts, or counts of unplanned events versus total events, including exposures (such as operational hours or starts) on the parts or events. These models provide insight into the mechanism of the part unrepairability or unplanned event reasons, such as infant mortality versus wear out, and can also indicate the effectiveness of product and process improvements. Some examples of typical reliability analysis include Weibull and Exponential distribution models.

As used herein, "contemporaneously with service outage" indicates that the processes, i.e., P20 and P30, are performed within a short period of time, e.g., within days, weeks or a couple months, of the service outage of turbomachine 100 that provides the time to perform the evaluation, recording of impairment mode and reliability modeling. Consequently, the disadvantages of the current process and its related lapsed time can be overcome.

Embodiments of CDCM system 130 as described herein remove the time lapse from the point of unplanned outage or unrepairable part to the time when reliability modeling is performed, improving modeling accuracy. In addition, since the recording and modeling are performed contemporaneously with the service outage, all structures, stored data and knowledgeable personnel are typically readily available such that all relevant data can be collected. Further, embodiments of the disclosure provide predefined impairment modes, which act to more precisely categorize parts and/or events so that more accurate modeling can be carried out. Since the recording and modeling are conducted more frequently, modeling backlogs are removed.

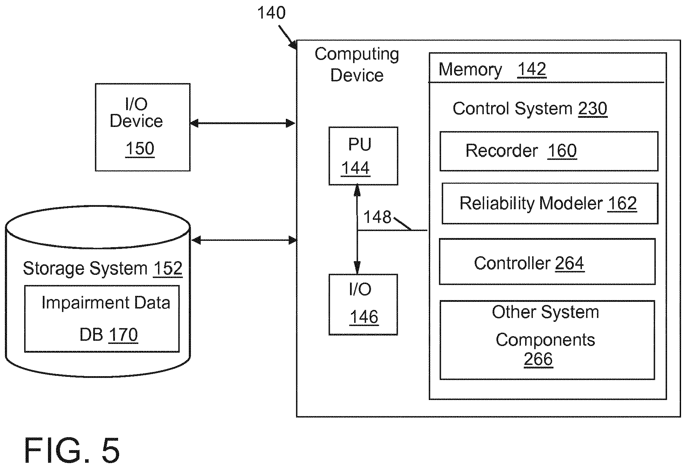

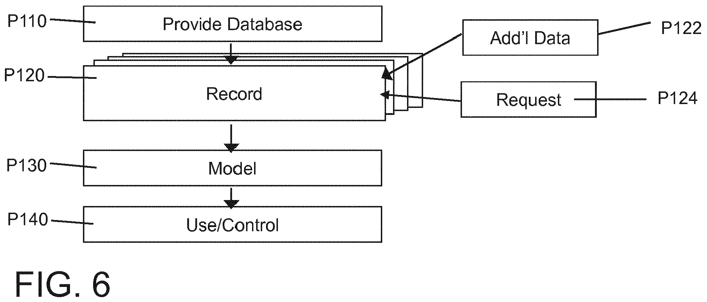

Referring to FIGS. 4-6, in an alternative embodiment, turbomachine 100 (FIG. 1) may be controlled by a control system 230 (FIG. 5) operative to control operation of turbomachine 100 and its various sections based on a reliability model, discussed herein. With reference to FIG. 5, a schematic block diagram of control system 230 in accordance with the disclosure is illustrated. Control system 230 is substantially structurally similar to CDCM system 130. As discussed further below, control system 230 may include or be part of any now known or later developed controller for turbomachine 100. For clarity, control system 230 is shown with only those components that are relevant to operation of the disclosure. For purposes of the disclosure, control system 230 may include recorder 160, reliability modeler 162 and a controller 264. As understood, control system 130 may include a large number of other system components 266 for operating the various parts of turbomachine 100.

FIG. 5 shows a flow diagram of an embodiment of a method for controlling turbomachine 100 including a plurality of parts is illustrated. Referring to FIGS. 4-6 collectively, operation of control system 230 relative to processes P110, P120, P122, P124 and P130 are identical to processes P10, P20, P22, P24 and P30, respectively, discussed relative to FIGS. 2-4 herein.

In this embodiment, in process P140, controller 264 uses the reliability modeling to control operation of turbomachine 100 (FIG. 1) after the service outage. That is, the modeling is updated based on the impairment mode and any other data gained, and controller 264 uses the updated reliability modeling to control turbomachine 100. Controller 264 and other system components 266 may include any now known or later developed turbomachine control system capable of using modeling results to assist in controlling the turbomachine 100, e.g., by predicting when maintenance is required, changing operations to prolong part life, etc.

As with CDCM system 130, embodiments of control system 230 remove the time lapse from the point of unplanned outage or unrepairable part to the time when reliability modeling is performed, improving modeling accuracy. In addition, since the recording and modeling are performed contemporaneously with the service outage, all structures, stored data and knowledgeable personnel are typically readily available such that all relevant data can be collected. Further, embodiments of the disclosure provide predefined impairment modes, which act to more precisely categorize parts and/or events so that more accurate modeling can be carried out. Since the recording and modeling are conducted more frequently, modeling backlogs are removed.

The present disclosure may be embodied as a system, a method, and/or a computer program product. The computer program product may include a computer readable storage medium (or media) having computer readable program instructions thereon for causing a processor to carry out aspects of the present disclosure. The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals *per se,* such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Java, Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to embodiments of the disclosure. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments of the present disclosure. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

The terminology used herein was chosen to best explain the principles of the embodiments, the practical application or technical improvement over technologies found in the marketplace, or to enable others of ordinary skill in the art to understand the embodiments disclosed herein.

## Claims

1. A system for controlling a turbomachine (100), comprising:
a database (170) including impairment data for a turbomachine (100);
a recorder (160) recording in the database (170) an impairment mode for at least one of a part or an event from a plurality of predetermined impairment modes contemporaneously with a service outage of the turbomachine (100); and
a reliability modeler (162) modeling a reliability of the at least one of the part and the event based on the database (170) contemporaneously with the service outage.

2. The system of claim 1, wherein the recorder (160) accepts a request (182) for additional data regarding the at least one of the part and the event, and records the additional data regarding the at least one of the part and the event based on the request (182) or the recorder (160) records additional data regarding the at least one of the part and the event, wherein the additional data includes an image of the part.

3. The system of claim 1, wherein the recorder (160) records the impairment mode at a plurality of collection nodes, wherein the plurality of collection nodes is selected from the group consisting of: a part repair location, a turbomachine (100) location, and a test lab location.

4. A method for controlling a turbomachine (100) including a plurality of parts, the method comprising:
providing a database (170) including impairment data for the turbomachine (100);
recording in the database (170) an impairment mode for at least one of a part or an event from a plurality of predetermined impairment modes contemporaneously with a service outage of the turbomachine (100);
modeling a reliability of the at least one of the part and the event based on the database (170) contemporaneously with the service outage; and
using the reliability modeling to control operation of the turbomachine (100) after the service outage.

5. The method of claim 4, further comprising accepting a request (182) for additional data regarding the at least one of the part and the event, and wherein the recording the impairment mode includes recording the additional data regarding the at least one of the part and the event based on the request (182).

6. The method of claim 4, wherein the recording of the impairment mode includes recording additional data regarding the at least one of the part and the event.

7. The method of claim 6, wherein the additional data includes an image of the part.

8. The method of claim 4, further comprising, in response to the part being identified as scrap, performing testing on the part and recording a result of the testing in the database (170).

9. The method of claim 4, wherein the recording occurs at a plurality of collection nodes.

10. The method of claim 9, wherein the plurality of collection nodes is selected from the group consisting of: a part repair location, a control system (130, 230) of the turbomachine (100), a turbomachine (100) location, and a test lab location.

11. The method of claim 4, wherein the service outage is unplanned.

12. A computer program product which performs the method of claim 4.
